# EUROPEAN PATENT APPLICATION

(11) **EP 4 142 133 A1**
(43) Date of publication of application: **01.03.2023**
(21) Application number: 21306167.4
(22) Date of filing: 30.08.2021
(51) Int. Cl.: H02M 3/06, G01R 15/04, G01R 15/06, H01L 29/66, H01L 23/522, H01L 23/64, H01L 27/08, H01L 49/02

(54) **AN ELECTRICAL DEVICE COMPRISING AN AC VOLTAGE DIVIDER AND CAPACITORS ARRANGED IN INTEGRATED COMPONENTS**

(71) Applicant: Murata Manufacturing Co., Ltd., Nagaokakyo-shi, Kyoto 617-8555 (JP)
(72) Inventor: MULLER, Charles, 14000 CAEN (FR)
(74) Representative: Cabinet Beau de Loménie

(57) **Abstract**

An electrical device comprising an AC voltage divider comprising a board (BRD), a plurality of dividing stages each associated with a dividing ratio (Q), an input terminal (301) arranged on the board for receiving an input voltage, and an output terminal (302) arranged on the board for outputting a divided voltage,
wherein each dividing stage comprises a plurality of capacitors, and for each dividing stage, the plurality of capacitors of this dividing stage is arranged in a same integrated component (200A, 200B, 200C) assembled on the board and electrically connected between the input terminal and the output terminal.

The invention also concerns the corresponding manufacturing method.

## Description

### Field of the Invention

The present invention relates to the field of electrical devices, and more precisely to the field of electrical devices including AC voltage dividers.

### Technical Background

AC voltage dividers are typically used in power applications where AC voltages need to be divided.

To this end, discrete Multilayer Ceramic Capacitors (MLCC) are assembled using Chip-On-Board (COB) techniques as high capacitance values can be required. It can be conceived that the capacitance values of these MLCC capacitors need to be carefully monitored when used in a voltage divider. By way of example, a tolerance of 2% on the capacitance value, or even 1%, can be required. This can be particularly difficult to achieve, and requires a preliminary sorting of the components.

The MLCC components can have a size of the order of 3.2mm by 1.6mm, which may be an issue in terms of integration and compactness. In particular, for high voltage applications where the MLCC components are located close to inverters, the available space is limited and the thermal constraints are critical.

These systems are prone to risks of sparks/short-circuits, and also derating. MLCC components are particularly known for their derating (this is also true for other types of capacitors such as tantalum capacitors and electrochemical capacitors).

From the prior art, the following documents are known:
- Document CN 105137378 discloses a voltage divider which self-calibrates.
- Document US 10461040 discloses a structure with MLCC capacitors having identical properties.
- Document CN 101915860 discloses a voltage divider terminal structure.
- Document US 6518814 discloses an integrated voltage capacitor formed above an SOI substrate.

There exists a need for precisely matched capacitors that can be used in voltage dividers.

The present invention has been made in the light of the above problems.

### Summary of the Invention

The present invention provides an electrical device comprising a board, an AC voltage divider comprising a plurality of dividing stages each associated with a dividing ratio, an input terminal arranged on the board for receiving an input voltage, and an output terminal arranged on the board for outputting a divided voltage,

wherein each dividing stage comprises a plurality of capacitors, and for each dividing stage, the plurality of capacitors of this dividing stage is arranged in a same integrated component assembled on the board and electrically connected between the input terminal and the output terminal.

A dividing stage comprises an intermediary input terminal (arranged on the integrated component), an intermediary output terminal (arranged on the integrated component, typically connected to the middle point between two capacitors), and a ground terminal (arranged on the integrated component). The intermediary input terminal can be connected to the input terminal of the board or to an intermediary output terminal of another dividing stage, and the intermediary output terminal can be connected to the output terminal of the board or to an intermediary input terminal of another dividing stage.

By way of example, a stage comprises two capacitors.

By forming the capacitors of a same stage in an integrated component, these capacitors can be formed using parallel manufacturing techniques, which reduces the possibility of a mismatch between the electrical parameters of these capacitors. In fact, a deviation of any electrical parameter (for example the capacitance which varies in accordance with a dielectric thickness deviating from a nominal value) can affect the individual electrical parameters of the capacitors but not the dividing ratio of the stage corresponding to this component, as long as deviations are proportional to the nominal values. Consequently, by grouping together capacitors of a same dividing stage in an integrated component, tolerance requirements on individual components are loosened as the dividing ratio is not always affected when a parameter deviates from its nominal value.

Further, the capacitors of a same integrated component will be affected by temperature similarly, while the dividing ratio may remain stable.

It has been observed that the individual capacitance values are not as useful as the dividing ratios, when designing a voltage divider. Hence, the proposed structure overcomes the need to control the individual capacitance values.

Any integrated manufacturing technology can be used, as long as the same manufacturing process is used to manufacture all the capacitors of a same dividing stage, in parallel.

This results in a matching between the capacitors of a same stage. By a matching, what is meant is that specific parameters of these capacitors will be identical, for example: the dielectric thickness, the dielectric composition, the electrode thickness, the electrode composition. In fact, this matching is a consequence of manufacturing the capacitors of a same stage in a same integrated component, which share the same manufacturing steps (they are preferably manufactured in parallel - as they are made in a same integrated component).

Also, integrating capacitors in an integrated component increases the reliability of the device and prevents the occurrence of sparks in high voltage applications (while also allowing low voltage applications).

According to a particular embodiment, the device comprises a plurality of distinct integrated components, each integrated component comprising the plurality of capacitors of a single dividing stage.

It has been observed that it is preferable to separate the dividing stages into a plurality of distinct integrated components as these dividing stages operate at different voltages and this provides a good insulation between the stages.

According to a particular embodiment, an integrated component comprises the plurality of capacitors of at least two dividing stages.

Alternatively, it is possible to conceive an integrated component including several dividing stages.

According to a particular embodiment, each dividing stage comprises only two capacitors (and no other passive component except connections and terminals).

According to a particular embodiment, each integrated component comprises an intermediary output port connected to the two capacitors (typically a middle point).

This intermediary output port allows exiting the integrated component so as to form a connection (for example using wire bonding) with a terminal on the board or with another integrated component (of another dividing stage).

According to a particular embodiment, the capacitors are 3D capacitors.

For example, a 3D capacitor comprises functional electrodes presenting a relief (for example they comprise a surface presenting a relief or they are formed on a relief such as a pore, a hole, a trench, or a pillar). 3D capacitors may also be defined as comprising functional electrodes extending in three directions orthogonal with each other (for example two directions parallel to the support and one direction orthogonal with the support). In the invention a functional electrode is an electrode which faces the other electrode of the capacitor and participates to the capacitance of the device. The capacitor terminals may be included in the functional electrodes, partially included in the functional electrodes, or may be connected to the functional electrodes. A functional electrode extending in the three directions is a functional electrode having an outer surface extending in these three directions.

According to a particular embodiment, capacitors arranged in a same integrated component are supported by a same semiconductor substrate (typically a silicon substrate).

By supported by, what is meant is that they are formed above or in this substrate, and for example arranged next to each other on this substrate.

According to a particular embodiment, the same semiconductor substrate (supporting the two capacitors) comprises a semiconductor region forming an electrode of each of said capacitors supported by the semiconductor substrate.

For example, the capacitors can be capacitors formed in accordance with the manufacturing processes described in document WO 2007/125510.

According to a particular embodiment, each integrated component is assembled as a chip-on-board module on the board.

According to a particular embodiment, an integrated component (i.e. an integrated component including a dividing stage having at least two capacitors) comprises:
a substrate (for example a semiconductor substrate),
above the substrate, a first bottom conductive region and a second bottom conductive region separated from the first bottom conductive region (for example formed by depositing and patterning a conductive layer),
a dielectric layer above the two separated conductive regions and the substrate, the dielectric layer having at least one opening above the first bottom conductive region (a through-opening that opens onto the first bottom conductive region),
a first top conductive region arranged above the dielectric layer and the first bottom conductive region so as to form a first capacitor (formed by the first bottom conductive region, the dielectric layer, and the first top conductive region facing the bottom conductive region),
a second top conductive region arranged above the dielectric layer and the second bottom conductive region so as to form a second capacitor (formed by the second bottom conductive region, the dielectric layer, and the second top conductive region facing the bottom conductive region),
wherein the second top conductive region extends to the opening of the dielectric layer so as to form an electrical connection between the second top conductive region and the first bottom conductive region, and so as to connect the first capacitor and the second capacitor (the second top conductive region forms an intermediary output port).

In this particular embodiment, the capacitor electrodes can be formed from a same layer, and the dielectric layer is shared between the two capacitors. A good matching is obtained.

This structure is also advantageous for some applications as the substrate can remain insulating and may not have to be used to form a capacitor electrode (typically the shared electrode between the capacitors). This can be used in situations where the material of the substrate is difficult to transform into a conductive material.

This structure also allows using a substrate which has to be connected to the ground. For example a supplementary insulating layer can be arranged between the substrate and the capacitors, eventually with an opening in this insulating layer to form an electrical connection between the substrate and a capacitor electrode which should be connected to the ground. Alternatively, the substrate may be locally doped to form a diode in a blocking state when the dividing stage is being used.

Also, this structure is advantageous when multiple integrated components have to be arranged close to one another as a non-conductive substrate prevents any electrical breakdown.

Finally, it should be noted that this structure is manufactured using steps analogous to the steps used to form MIMIM structures, well known to the person skilled in the art.

The invention further provides a method of manufacturing an electrical device comprising an AC voltage divider, the method comprising:
providing a board equipped with an input terminal for receiving an input voltage and an output terminal for outputting a divided voltage,
forming a plurality of dividing stages each associated with a dividing ratio, wherein each dividing stage comprises a plurality of capacitors, and for each dividing stage, the plurality of capacitors of this dividing stage is arranged in a same integrated component, and
assembling each integrated component on the board (or assembling the integrated component if all the dividing stages are arranged in a same integrated component), so as to electrically connect each integrated component between the input terminal and the output terminal.

This method can be adapted to the manufacture of any one of the embodiments of the device as defined above.

According to a particular embodiment, the method comprises using a chip-on-board process to assemble each integrated component on the board.

According to a particular embodiment, for each integrated component, the method comprises forming the capacitors of this integrated component using at least one parallel manufacturing process.

For example, the capacitors can be formed using a same deposition step, a same photolithography step, etc.

According to a particular embodiment, forming the plurality of capacitors of a same dividing stage in an integrated component comprises:
providing a substrate,
forming, above the substrate, a first bottom conductive region and a second bottom conductive region (for example by depositing a conductive layer and subsequently patterning this layer),
forming a dielectric layer above the two separated conductive regions and the substrate, the dielectric layer having at least one opening above the first bottom conductive region (for example by depositing a dielectric layer and subsequently patterning this layer to form the opening),
forming a first top conductive region above the dielectric layer and the first bottom conductive region so as to form a first capacitor,
forming a second top conductive region above the dielectric layer and the second bottom conductive region so as to form a second capacitor (for example by depositing a conductive layer and subsequently patterning this layer to obtain both the first and the second top conductive regions),
wherein the second top conductive region extends to the opening of the dielectric layer so as to form an electrical connection between the second top conductive region and the first bottom conductive region, and so as to connect the first capacitor and the second capacitor.

### Brief Description of the Drawings

Further features and advantages of the present invention will become apparent from the following description of certain embodiments thereof, given by way of illustration only, not limitation, with reference to the accompanying drawings in which:
- Figure 1 is a circuit diagram of an electrical device according to an example,
- Figure 2 is a cross section of an integrated component according to an example,
- Figures 3A and 3B illustrate forming an integrated component according to another example,
- Figure 4 is a top view of an electrical device according to an example.

### Detailed Description of Example Embodiments

We will now describe an electrical device comprising an AC voltage divider which uses integrated components equipped with dividing stages.

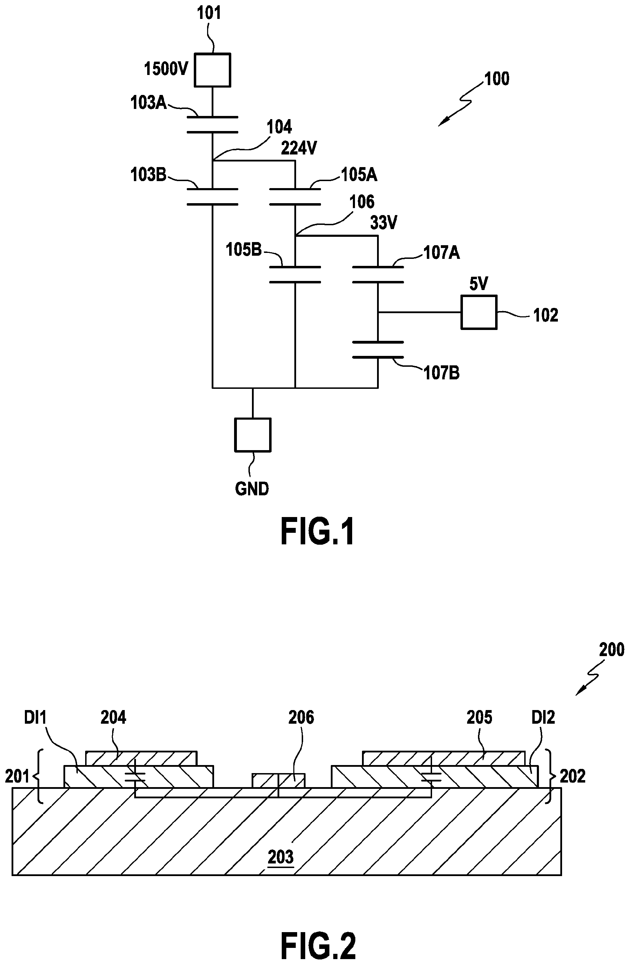

This device can be adapted for high-voltage applications (as will be described hereinafter in reference to figure 1), but also for low-voltage applications, as the capacitors are arranged in integrated devices and can benefit from the advantages of silicon technology, for example.

Figure 1 is a circuit diagram of a device 100 including a voltage divider. The board and the integrated components that form this voltage divider will be visible on the exemplary representations of figures 2, 3A, 3B and 4.

The device of figure 1 comprises an input terminal 101 able to receive a voltage of 1500V (high-voltage application), and an output terminal 102 which, through the voltage divider's operation, is configured to output a voltage of 5V.

To achieve this, a first dividing stage is connected to the input terminal 101. This first dividing stage comprises a capacitor 103A, connected to the input terminal and to an intermediary output terminal 104 (the output terminal of the first dividing stage), and a capacitor 103B, connected to the intermediary output terminal 104 and to the ground GND. Capacitor 103A has a capacitance of 1pF while capacitor 103B has a capacitance of 5.7pF. Both capacitors 103A and 103B are manufactured in parallel, on a same integrated component (i.e. above a same semiconductor substrate), as they belong to a same dividing stage. Their dividing ratio is equal to (1+5.7/1)=6.7, which leads to a voltage of about 224V outputted by this first dividing stage.

A second dividing stage is connected to the intermediary output terminal 104. This second dividing stage comprises a capacitor 105A, connected to the intermediary output terminal 104 and to an intermediary output terminal 106 (the output terminal of the second dividing stage), and a capacitor 105B, connected to the intermediary output terminal 106 and to the ground GND. Capacitor 105A has a capacitance of 1pF while capacitor 105B has a capacitance of 5.7pF. Both capacitors 105A and 105B are formed in parallel, on a same integrated component (preferably an integrated component distinct from the one of the first dividing stage), as they belong to a same dividing stage. Their dividing ratio is equal to (1+5.7/1)=6.7, which leads to a voltage of about 33V outputted by this second dividing stage.

A third dividing stage is connected to the intermediary output terminal 106. This third dividing stage comprises a capacitor 107A, connected to the intermediary output terminal 106 and to the output terminal 102, and a capacitor 107B, connected to the output terminal 102 and to the ground GND. Capacitor 107A has a capacitance of 1pF while capacitor 107B has a capacitance of 5.7pF. Both capacitors 107A and 107B are formed in parallel, on a same integrated component (preferably an integrated component distinct from the one of the first dividing stage and from the one of the second dividing stage), as they belong to a same dividing stage. Their dividing ratio is equal to (1+5.7/1)=6.7, which leads to a voltage of about 5V outputted by this third dividing stage.

It should be noted that in the circuit of figure 1, a deviation of a parameter of which will affect the capacitance (with respect to a nominal capacitance value) of a capacitor of a dividing stage will also affect the capacitance (also with respect to a nominal capacitance value) of the other capacitor of this same stage, because there is a matching of their parameters as they have been manufactured in parallel. Hence, the dividing ratio may be unaffected by a deviation of both capacitances.

Figure 2 is a cross section of an integrated component 200 that comprises two capacitors 201 and 202, for example to implement the first, the second, or the third dividing stage of the circuit of figure 1.

Both capacitors 201 and 202 are formed above a same semiconductor substrate 203 (typically but not necessarily silicon).

The semiconductor substrate 203 is used to connect the two electrodes of the capacitors. For example, it can be doped so as to be conductive in its entirety or locally doped so as to form an electrical connection between the capacitors 201 and 202.

The first capacitor will have its remaining elements, in addition to its bottom electrode formed in the substrate 203, above the substrate. Here, a dielectric region DI1 is formed above the substrate and an upper electrode 204 is formed on the dielectric region DI1. The upper electrode 204 is a connecting pad which allows a wire to be bonded. It also forms the intermediary input of the dividing stage.

The second also has its remaining elements, in addition to its bottom electrode formed in the substrate 203, above the substrate. Here, a dielectric region DI2 is formed above the substrate and an upper electrode 205 is formed on the dielectric region DI1. The upper electrode 204 is a connecting pad which allows a wire to be bonded, for example for a connection to the ground.

An electrical contact 206 is formed on the substrate, in the form of a connecting pad. This electrical contact 206 forms the intermediary output terminal of the dividing stage of this integrated component.

It should be noted that for the sake of simplicity, the capacitors are represented as 2D capacitors. However, in order to increase the capacitance of the capacitors, it is possible to use 3D capacitors. By way of example, 3D structures can be formed in the semiconductor substrate 203 to form pillars, trenches, or holes, that are then filled with a stack of dielectric and electrode.

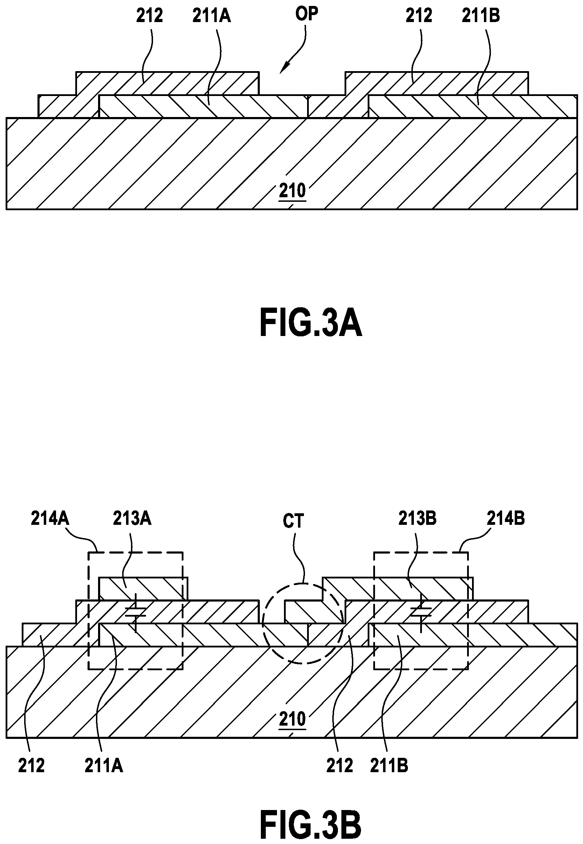

Figure 3A is a cross section of a structure which will form subsequently and as formed on figure 3B an integrated component. This structure comprises a substrate 210 which can be a semiconductor substrate, or even an insulating substrate.

Above the substrate 210, a first bottom conductive region 211A and a second bottom conductive region 211B separated from the first bottom conductive region are formed by depositing a conductive layer and patterning this layer to obtain the two regions.

Then, a dielectric layer 212 is formed, here in a conformal manner. An opening OP is formed in this layer above the first bottom conductive region.

As shown on figure 3B, a first top conductive region 213A is formed above the dielectric layer 212 and above the first bottom conductive region so as to form a first capacitor 214A.

Also, a second top conductive region 213B is formed above the dielectric layer 212 and above the second bottom conductive region so as to form second first capacitor 214B.

The second top conductive region extends to the opening OP of the dielectric layer so as to form an electrical connection CT between the second top conductive region and the first bottom conductive region, and so as to connect the first capacitor and the second capacitor.

This structure allows obtaining more flexibility on the type of substrate.

Also, additional electrodes can be formed, and the substrate can be connected to any one of the electrodes.

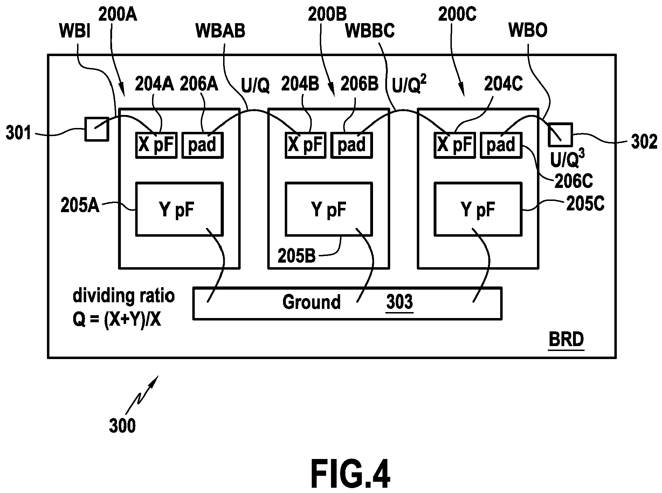

Figure 4 is a top view of an electrical device 300 comprising a board BRD and a plurality of dividing stages each consisting in a distinct integrated component.

More precisely, three dividing stages/integrated components 200A, 200B, and 200C are assembled on the board, using a chip-on-board technique, and wire bonding.

The integrated components 200A, 200B, and 200C are identical and have a structure which is similar to the component described in reference to figure 2.

Here, the board BRD comprises an input terminal 301 for receiving an input voltage, and a wire WBI is bonded between this input terminal and the intermediary input terminal 204A of component 200A. Another wire WBAB is bonded between the intermediary output terminal 206A and the intermediary input terminal 204B to connect the dividing stages 200A and 200B. In order to connect the dividing stages 200B and 200C, a wire WBBC is bonded between the intermediary output terminal 206B and the intermediary input terminal 204A. Finally, the intermediary output terminal 206C is connected to the output terminal 302 of the board.

Wires are also used to connect the dividing stages to a ground terminal 303 arranged on the board.

In the illustrated example, if each dividing stage is associated with a dividing ratio Q=(X+Y)/X (where X is the capacitance of the capacitor connected to the input and Y the capacitance of the capacitor connected to the ground), the output voltage for a given input AC voltage U is U/Q³.

The above described voltage dividers use capacitors that have capacitance values that can be disregarded when designing a voltage divider as long as the dividing ratio is known. This dividing ratio is particularly stable, as all the capacitors of a stage are formed in a same integrated component (and will therefore be affected similarly by an elevation of temperature, for example - it should be noted that this is also an advantage over MLCC components where the temperature derating is component dependent).

The present voltage divider benefits from the advantages of using a semiconductor substrate to manufacture capacitors.

Also, the capacitance used can be small, as only the ratio is relevant.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electrical device comprising an AC voltage divider comprising a board (BRD), a plurality of dividing stages each associated with a dividing ratio (Q), an input terminal (301) arranged on the board for receiving an input voltage, and an output terminal (302) arranged on the board for outputting a divided voltage,
wherein each dividing stage comprises a plurality of capacitors, and for each dividing stage, the plurality of capacitors of this dividing stage is arranged in a same integrated component (200A, 200B, 200C) assembled on the board and electrically connected between the input terminal and the output terminal.

2. The device of claim 1, comprising a plurality of distinct integrated components (200A, 200B, 200C), each integrated component comprising the plurality of capacitors of a single dividing stage.

3. The device of claim 1, wherein an integrated component comprises the plurality of capacitors of at least two dividing stages.

4. The device of any one of claims 1 to 3, wherein each dividing stage comprises only two capacitors.

5. The device of claims 3 and 4, wherein each integrated component comprises an intermediary output port (206A, 206B, 206C) connected to the two capacitors.

6. The device of any one of claims 1 to 5, wherein the capacitors are 3D capacitors.

7. The device of any one of claims 1 to 6, wherein capacitors arranged in a same integrated component are supported by a same semiconductor substrate (203).

8. The device of claim 7, wherein the same semiconductor substrate comprises a semiconductor region forming an electrode of each of said capacitors supported by the semiconductor substrate.

9. The device of any one of claim 1 to 8, wherein each integrated component is assembled as a chip-on-board module on the board.

10. The device of any one of claims 1 to 9, wherein an integrated component comprises:
a substrate (210),
above the substrate, a first bottom conductive region (211A) and a second bottom conductive region (211B) separated from the first bottom conductive region,
a dielectric layer (212) above the two separated conductive regions and the substrate, the dielectric layer having at least one opening (OP) above the first bottom conductive region,
a first top conductive region (213A) arranged above the dielectric layer and the first bottom conductive region so as to form a first capacitor,
a second top conductive region (213B) arranged above the dielectric layer and the second bottom conductive region so as to form a second capacitor,
wherein the second top conductive region extends to the opening of the dielectric layer so as to form an electrical connection (CT) between the second top conductive region and the first bottom conductive region, and so as to connect the first capacitor and the second capacitor.

11. A method of manufacturing an electrical device comprising an AC voltage divider, the method comprising:
providing a board (BRD) equipped with an input terminal (301) for receiving an input voltage and an output terminal (302) for outputting a divided voltage,
forming a plurality of dividing stages each associated with a dividing ratio, wherein each dividing stage comprises a plurality of capacitors, and for each dividing stage, the plurality of capacitors of this dividing stage is arranged in a same integrated component (200A, 200B, 200C), and
assembling each integrated component on the board, so as to electrically connect each integrated component between the input terminal and the output terminal.

12. The method of claim 11, comprising using a chip-on-board process to assemble each integrated component on the board.

13. The method of claim 11 or 12, comprising, for each integrated component, forming the capacitors of this integrated component using at least one parallel manufacturing process.

14. The method of any one of claims 11 to 13, wherein forming the plurality of capacitors of a same dividing stage in an integrated component comprises:
providing a substrate (210),forming, above the substrate, a first bottom conductive region (211A) and a second bottom conductive region (211B),
forming a dielectric layer (212) above the two separated conductive regions and the substrate, the dielectric layer having at least one opening (OP) above the first bottom conductive region,
forming a first top conductive region (213A) above the dielectric layer and the first bottom conductive region so as to form a first capacitor,
forming a second top conductive region (213B) above the dielectric layer and the second bottom conductive region so as to form a second capacitor,
wherein the second top conductive region extends to the opening of the dielectric layer so as to form an electrical connection (CT) between the second top conductive region and the first bottom conductive region, and so as to connect the first capacitor and the second capacitor.
